# EUROPEAN PATENT APPLICATION

(11) **EP 4 632 806 A1**
(43) Date of publication of application: **15.10.2025**
(21) Application number: 25164694.9
(22) Date of filing: 19.03.2025
(51) Int. Cl.: H01L 23/34, H01L 23/46, F28F 9/26, H05K 7/20

(54) **COOLING ARRANGEMENT AND METHOD FOR COOLING POWER ELECTRONICS ASSEMBLY USING COOLING ARRANGEMENT**

(30) Priority: 09.04.2024 FI 20245439
(71) Applicant: Vensum Power Oy, 02150 Espoo (FI)
(72) Inventor: Mononen, Reijo, 04400 Järvenpää (FI); Sahlsten, Oiva, 24280 Salo (FI)
(74) Representative: Moosedog Oy

(57) **Abstract**

Disclosed is a cooling arrangement (100), comprising: a first cooling unit (120) having a first hollow elongated body (122) that provides a passage for a fluid to flow through the first cooling unit (120); a second cooling unit (140), arranged parallel to and spaced apart from the first cooling unit (120), having a second hollow elongated body (142) that provides a passage for a fluid to flow through the second cooling unit (140); one or more magnetic devices (160) arranged between the first cooling unit (120) and the second cooling unit (140); and one or more fluid transfer means (180, 190, 192) that enable transfer of fluid through the first cooling unit (120) and the second cooling unit (140).

## Description

### TECHNICAL FIELD

The present disclosure relates to cooling systems for high-power electrical or electronic units. The present disclosure also relates to a cooling arrangement and a method for cooling a power electronics assembly using the cooling arrangement.

### BACKGROUND

A cooling system can be a critical component in an (electrical/electronic) device, as cooling components, especially high-power components, of the device may be necessary for ensuring continuity of effective, reliable, and efficient operation of the device. The components of the device are likely to get heated during operation of the device due to a plurality of factors such as internal resistances, conduction losses, switching losses, and so on. In high-power devices, certain internal mechanisms associated with the operation of the high-power devices and electrical characteristics may lead to an initial heat generation. In absence of a robust cooling system (such as inadequate heat sink or airflow), the initially generated heat may trigger a cascading effect, whereby the initially generated heat may lead to further heat generation (due to heat accumulation). In some scenarios, a positive feedback loop associated with the heat generation may cause a rapid and continuous rise in temperature until there is an occurrence of thermal runaway in the high-power devices.

For dissipation of excessive heat from components of power electronic devices (for example, electronic controllers, integrated gate-commutated thyristors, power converters, insulated gate bipolar transistors, motor drives, and so on), cooling systems such as heat sinks, thermoelectric cooling, liquid cooling, forced air cooling, may be used. The heat sinks are constructed using thermally conductive materials and connected to the components for increasing surface area for heat dissipation based on conduction. The heat sinks may be used in combination with forced air cooling to facilitate transfer of heat from the components to surrounding air. Such cooling systems may not be effective as heat sinks may have a high thermal resistance. The high thermal resistance may not facilitate transforming thermal output (resulting from power dissipation loss) into the heat sinks. Further, in an absence of a clear path for driving out warm air, collected from the components via heat sinks, implementation of forced air cooling may be challenging.

Additionally, cooling magnetics components, i.e., passive elements that rely on an internal magnetic field to alter electrical current, and critical high-power components of the power electronic devices may present a significant challenge as the magnetics components are bulky. Further, keeping power ratings short, i.e., minimize one or more of resistive, inductive, and capacitive losses may be challenging as well. These factors may reduce power output and, hence, efficiency of the power electronic devices.

Therefore, considering the foregoing discussion, there exists a need to overcome the aforementioned drawbacks.

### SUMMARY

The aim of the present disclosure is to provide a cooling arrangement and a method for cooling a power electronics assembly using the cooling arrangement. The cooling arrangement may include one or more cooling units that include heat exchange surfaces with low thermal resistance and one or more fluid transfer means. The cooling arrangement facilitates collection of heat, which may be generated by the electrical or electronic components of the power electronics assembly mounted on the cooling arrangement, via the one or more heat exchange surfaces of the cooling units and the fluid transfer means allows dissipation of the collected heat by enabling passage of fluids through the cooling units. Thus, the cooling arrangement facilitates effective cooling of different components of the power electronics assembly. The aim of the present disclosure is achieved by the provided cooling arrangement and the method for cooling a power electronics assembly using the cooling arrangement as defined in the appended independent claims to which reference is made to. Advantageous features are set out in the appended dependent claims.

Throughout the description and claims of this specification, the words *"comprise", "include", "have",* and *"contain"* and variations of these words, for example *"comprising"* and *"comprises",* mean *"including but not limited to",* and do not exclude other components, items, integers, or steps not explicitly disclosed also to be present. Moreover, the singular encompasses the plural unless the context otherwise requires. In particular, where the indefinite article is used, the specification is to be understood as contemplating plurality as well as singularity, unless the context requires otherwise.

### BRIEF DESCRIPTION OF THE DRAWINGS

FIG. 1A illustrates of an exemplary power electronics assembly that includes a cooling arrangement and a power electronics unit, according to an embodiment of the present disclosure;
FIG. 1B is a schematic that illustrates a top view of an exemplary cooling arrangement for cooling a power electronics unit, in accordance with an embodiment of the present disclosure;
FIG. 2A is a schematic that illustrates a top view of an exemplary cooling arrangement that includes two extension bodies, in accordance with an embodiment of the present disclosure;
FIG. 2B is another schematic that illustrates a top view of an exemplary cooling arrangement that includes two extension bodies, in accordance with an embodiment of the present disclosure;
FIG. 3A illustrates an exemplary hollow elongated body of a cooling unit that is of a polygonal elongated shape and comprises a plurality of fins, in accordance with an embodiment of the present disclosure;
FIG. 3B illustrates an exemplary hollow elongated body of a cooling unit that is of a rectangular shape and comprises a plurality of fins, in accordance with various embodiments of the present disclosure;
FIG. 4 is a schematic that illustrates a backside view of an exemplary power electronics assembly that includes a cooling arrangement and a power electronics unit, in accordance with an embodiment of the present disclosure; and
FIG. 5 depicts steps of a method for cooling a power electronics assembly, in accordance with an embodiment of the present disclosure.

### DETAILED DESCRIPTION OF EMBODIMENTS

The following detailed description illustrates embodiments of the present disclosure and ways in which they can be implemented. Although some modes of carrying out the present disclosure have been disclosed, those skilled in the art would recognize that other embodiments for carrying out or practising the present disclosure are also possible.

In a first aspect, the present disclosure provides a cooling arrangement, comprising:
a first cooling unit having a first hollow elongate body that provides a passage for a fluid to flow through the first cooling unit;
a second cooling unit, arranged parallel to and spaced apart from the first cooling unit, having a second hollow elongate body that provides a passage for a fluid to flow through the second cooling unit;
one or more magnetic devices arranged between the first cooling unit and the second cooling unit; and
one or more fluid transfer means that enable transfer of fluid through the first cooling unit and the second cooling unit.

In a second aspect, the present disclosure provides a power electronics assembly comprising:
a cooling arrangement, comprising:
   a first cooling unit having a first hollow elongate body that provides a passage for a fluid to flow through the first cooling unit,
   a second cooling unit, arranged parallel to and spaced apart from the first cooling unit, having a second hollow elongate body that provides a passage for a fluid to flow through the second cooling unit,
   one or more magnetic devices arranged between the first cooling unit and the second cooling unit, and
   one or more fluid transfer means that enable transfer of fluid through the first cooling unit and the second cooling unit; and
a power electronics unit that includes a printed circuit board (PCB), wherein a plurality of electronic components is arranged on a first side of the PCB, wherein the first side of the PCB is facing away from the first cooling unit and the second cooling unit, and wherein a second side of the PCB is facing the one or more magnetics devices.

In a third aspect, the present disclosure provides a method for cooling a power electronics assembly, the method comprising:
arranging one or more magnetic devices in contact with and between a first cooling unit and a second cooling unit, wherein the second cooling unit is in parallel to and spaced apart from the first cooling unit;
arranging a power electronics unit in contact with the first cooling unit and the second cooling unit, wherein a first side of the power electronics unit is facing away from the first cooling unit and the second cooling unit, and wherein a second side of the power electronics unit is facing towards the one or more magnetic devices;
supplying fluid through each of the first cooling unit and the second cooling unit by use of one or more fluid transfer means;
enabling collection of heat energy from the one or more magnetic devices via heat exchange surfaces of the first cooling unit and the second cooling unit in contact with the one or more magnetic devices;
enabling collection of heat energy from the power electronics unit via heat exchange surfaces of the first cooling unit and the second cooling unit in contact with the second side of the power electronics unit; and
ejecting the collected heat energy from the first cooling unit and the second cooling unit by means of the supplied fluid.

The present disclosure provides the aforementioned first aspect, the aforementioned second aspect, and the aforementioned third aspect to provide a cooling arrangement for cooling a power electronics unit (such as a power converter, a power controller, a switching device, and so on). The cooling arrangement includes a set of cooling units (i.e., the first cooling unit and the second cooling unit). Each cooling unit of the set of cooling units is having a hollow elongate body. The hollow elongate body of each of the first cooling unit and the second cooling unit may include heat exchange surfaces with minuscule thermal resistances. The power electronic assembly can be mounted on the heat exchange surfaces. The heat exchange surfaces enable transfer of heat, which may be generated due to power dissipation at components of the power electronic assembly. The heat may be transferred into the cooling units via conduction means. The heat exchange surfaces may be supplied with thermal interface material that facilitates the conduction. Optionally, in this regard, each heat exchange surface is provided with an internal cavity that is at least partly filled with the thermal interface material to reduce thermal resistance. The cooling arrangement further includes the fluid transfer means that enable transfer of fluid (such as liquid or gas) through the first cooling unit and the second cooling unit. The transferred fluid enables ejection of heat, which was collected by the heat exchange surfaces of the hollow elongate body of each cooling unit based on conduction, from the first cooling unit and the second cooling unit.

The cooling arrangement provides an effective and efficient mechanism for cooling the power electronics unit, compared to conventional cooling systems that utilize heatsinks and forced air cooling mechanisms. This is because the thermal resistances of the heat exchange surfaces of the cooling units may be 0.1 Kelvin/Watt (K/W) or better which is several orders of magnitude lower than typical heatsinks. It might be for example it can be 0.09, 0.08, 0.07, 0.06, 0.05, 0.04, 0.03, 0.02 or 0.01 K/W. This allows seamless collection of heat via the heat exchange surfaces. The cooling units may have a geometry (such as circular or polygonal) that is suitable for heat exchange surfaces. Additionally, the cooling units may include an assembly of fins and lamellas that may facilitate ejection of heat from the cooling units based on usage of a fluid that passes through the cooling units. The fluid transfer means (such as fans or pumps) may facilitate the transfer of fluids (such as air or water), which may be generated by the fluid transfer means, in a controlled manner through internal structures of the hollow elongate bodies of the cooling units. The internal structures are free from barriers or obstacles, which allows seamless navigation of fluid through the cooling units and ejection of the heat collected via the heat exchange surfaces of the cooling units.

The magnetic devices of the cooling arrangement in combination with the cooling units may enable an effective cooling of high-power magnetics (i.e., passive elements such as inductors and capacitors) of the power electronics unit. A design (i.e., such as the cooling arrangement) that combines cooling units and customized magnetics may provide an efficient cooling of high-power magnetic components. This is because a greater surface area of contact between the cooling units and the high-power magnetic components may be realized by the design. The heat exchange surfaces of the cooling units may facilitate transfer of heat from the high-power magnetic components through conduction. The greater surface area of contact may increase the cooling efficiency. The structure of the cooling arrangement is such that space utilization of the cooling units and the magnetic devices is optimized. The optimization may be achieved by ensuring that height of the magnetics and the cooling unit is identical or mechanical means. Additionally, the fluid transfer means may facilitate transfer of fluids through the magnetics such that effective thermal handling of magnetic windings is achieved.

Additionally, the structure of the cooling arrangement is modular. Thus, the construction of the cooling arrangement enables easier disassembling of different components, such as high-power components, or low-voltage components, of the power electronics unit. This simplifies maintenance and/or upgrade of the components of the power electronics unit. For example, replacement of wearing components, such as a malfunctioning high-power component with a functioning high-power component or an old low-voltage component with a new low-voltage component may be expedited, and utilization of resources (cost) involved in the replacement of the wearing components may be minimized due to the modularity of the cooling arrangement. The modularity enables operating the power electronics unit at different power levels based on swapping of low-power components of the power electronics unit with high-power components or swapping of high-power components of the power electronics unit with low-power components. The swapping allows introducing new features in the power electronics unit. The construction of the cooling arrangement allows connecting power electronic components of the power electronics unit directly with the cooling units.

The first cooling unit is having a first hollow elongated body. The first hollow elongated body provides a passage for fluid (such as liquid, air, or gas) to flow through the first cooling unit. The passing of the fluid through the passage may enable dissipation of heat from the first elongated body (i.e., the first cooling unit). The heat may be collected via one or more surfaces of the first cooling unit and may be present within the first hollow elongated body. The collection of the heat may be due to a contact between the first cooling unit and a power electronics unit.

The second cooling unit is having a second hollow elongated body. The second cooling unit is arranged parallel to and spaced apart from the first cooling unit. Thus, there is a gap of a certain dimension between the first cooling unit and the second cooling unit. The second hollow elongated body provides a passage for the fluid (such as the liquid, air, or gas) to flow through the second cooling unit. The passing of the fluid through the passage may enable dissipation of heat from the second elongated body (i.e., the second cooling unit). The heat may be collected via one or more surfaces of the second cooling unit and may be present within the second hollow elongated body. The collection of the heat may be due to a contact between the second cooling unit and the power electronics unit.

In an embodiment, the power electronics unit may be mounted on the first cooling unit and the second cooling unit. The power electronics unit may be in contact with a surface of the first cooling unit and a surface of the second cooling unit. Thus, the power electronics unit may be mounted on the surface of the first cooling unit and the surface of the second cooling unit. The heat collected by the surfaces of the first cooling unit and the second cooling unit may be generated due to dissipation of power at components (for example, a high-power component or a low-voltage component) of the power electronics unit. The generated heat may be transferred to the first hollow elongated body based on collection of the generated heat via the surface of the first cooling unit. Similarly, the generated heat may be transferred to the second hollow elongated body based on collection of the generated heat via the surface of the second cooling unit.

The transfer of heat may be due to conduction facilitated by the contact between the surface of the first hollow elongated body and the power electronics unit and the contact between the surface of the second hollow elongated body and the power electronics unit. The heat in the first hollow elongated body may be dissipated from the first hollow elongated body based on the passage of the fluid through the first hollow elongated body (the first cooling unit). Similarly, the heat in the second hollow elongated body may be dissipated from the second hollow elongated body based on the passage of the fluid through the second hollow elongated body (the second cooling unit). In accordance with an embodiment, each of the first cooling unit and the second cooling unit may be one of a high-capacity cooling aggregate, a segment cooling aggregate, or a miniature cooling aggregate.

Optionally, each of the first hollow elongated body and the second hollow elongated body may be of a rectangular shape or a polygonal elongate shape (such as hexagonal or octagonal shapes). The geometry of the first hollow elongated body of the first cooling unit may enable seamless navigation of the fluid through the first hollow elongated body (i.e., the first cooling unit). Similarly, the geometry of the second hollow elongated body of the second cooling unit may enable seamless navigation of the fluid through the second hollow elongated body (i.e., the second cooling unit). The cooling arrangement is designed such that internal structures of the first hollow elongated body and the second hollow elongated body allow navigation of the fluid through the first hollow elongated body and the second hollow elongated body respectively is without any obstruction. The free or unobstructed flow of the fluid through the internal structure of the first hollow elongated body may facilitate dissipation or ejection of heat from the first elongated body, and, thereby, an effective cooling of the first cooling unit. Similarly, the free or unobstructed flow of the fluid through the internal structure of the second hollow elongated body may facilitate dissipation or ejection of heat from the second elongated body, and, thereby, an effective cooling of the second cooling unit.

Optionally, the first hollow elongated body may be formed by a first heat sink profile and a casing and/or the second hollow elongated body may be formed by a second heat sink profile and a casing. The first heat sink profile and the casing may be designed to ensure effective heat transfer between the first cooling unit and the power electronics unit and, similarly, the second heat sink profile and the casing may be designed to ensure effective heat transfer between the second cooling unit and the power electronics unit.

The first heat sink profile indicates a design, geometry, characteristics, and so on, of a heat sink (such as the first cooling unit). Similarly, the second heat sink profile indicates a design, geometry, characteristics, and so on, of another heat sink (such as the second cooling unit). The first heat sink profile is selected based on the geometry of the first hollow elongated body, cooling or heat dissipation requirements of the power electronics unit mounted on the first cooling unit, dimensions of the first hollow elongated body, the internal structure of the first hollow elongated body, conditions of the first hollow elongated body through which the fluid may flow through the first cooling unit, and so on. Similarly, the second heat sink profile may be selected based on the geometry of the second hollow elongated body, cooling or heat dissipation requirements of the power electronics unit mounted on the second cooling unit, dimensions of the second hollow elongated body, the internal structure of the second hollow elongated body, conditions of the second hollow elongated body through which the fluid may flow through the second cooling unit, and so on. Exemplary heat sink profiles may include an extruded heat sink profile, cross-cut heat sink profile, folded fin heat sink profile, liquid cooled heat sink profile, and so on. Beneficially, besides ensuring effective heat transfer between the cooling units and the components being cooled, the casing provides structural integrity and protection for the cooling units, enhancing durability and reliability in various operating conditions.

Optionally, each of the first hollow elongated body and the second hollow elongated body further comprises a plurality of fins. The plurality of fins may extend or protrude from one or more surfaces of the first hollow elongated body and one or more surfaces of the second hollow elongated body. In some embodiments, the plurality of fins may be soldered on the one or more surfaces of the first hollow elongated body and the one or more surfaces of the second hollow elongated body. Alternatively, the fins may be extruded or mechanically attached to the one or more surfaces of the first and second hollow elongated bodies, depending on the manufacturing process. The plurality of fins allows expansion of a surface area that may be available for dissipation of heat through convection means. The heat is collected from components of the power electronics unit mounted on the first hollow elongated body and the second hollow elongated body. The fins of the plurality of fins may have a circular pattern, a helical pattern, or a spiral pattern. Optionally, the fins are thermally conductive and are in direct thermal contact with the first and second hollow elongated bodies, allowing them to transfer heat from the cooling units to the surrounding environment. In this regard, optionally, the fins are fabricated using thermally conductive materials such as aluminum or copper, which have high thermal conductivity and are lightweight. Optionally, the fins may be oriented in specific patterns, such as: perpendicular to the first and second hollow elongated bodies (to maximize the surface area exposed to airflow or fluid flow, enhancing heat dissipation), parallel to the fluid flow inside the first and second hollow elongated bodies (to ensure that heat is efficiently transferred from the fluid inside the cooling unit to the fins) and/or helical or spiral patterns (to optimize heat transfer in compact designs or to create turbulence in the surrounding airflow, further improving cooling efficiency).

Optionally, the first cooling unit comprises a first heat exchange surface that may correspond to an upper surface of the first hollow elongated body. In an embodiment, the power electronics unit is mounted on the first heat exchange surface (i.e., the upper surface of the first hollow elongated body). The first cooling unit further comprises a second heat exchange surface that may correspond to a side surface of the first hollow elongated body. The second heat exchange surface (i.e., the side surface of the first hollow elongated body) may be facing the second cooling unit. Optionally, at least one of the first heat exchange surface and the second heat exchange surface may be supplied with a thermal interface material. Herein, the term *"thermal interface material"* refers to materials with high thermal conductivity, such as thermal pastes, gels, or phase-change materials, which are used to improve heat transfer between two surfaces. The thermal interface material ensures that heat generated by the magnetic devices (high-power components that generate significant heat during operation) is effectively transferred to the cooling units. Thus, the reduction in thermal resistance minimizes heat buildup in the magnetic devices, preventing overheating and improving their performance and reliability. Moreover, by integrating the cavities comprising thermal interface material into the lateral heat exchange surfaces of the cooling units, the design ensures consistent and efficient thermal contact; and eliminates the need for bulky external heat sinks or additional cooling components. Thus, resulting in a more compact and space-efficient cooling arrangement. In an example, such design may be utilized in in power electronics assemblies.

As mentioned above, the first heat exchange surface and the second heat exchange surface are provided with (or comprises) internal cavities adjacent thereto. Optionally, the cavities may be formed as a channel, groove, or pocket within the structure of the cooling unit. The cavities are at least partially filled with the thermal interface material or thermally conductive material. The first heat exchange surface may facilitate conduction, i.e., transfer of heat from the power electronics unit to the upper surface of the first hollow elongated body. The thermal resistance of the first heat exchange surface may be several orders of magnitude lower compared to that of the conventional heatsinks. The lower thermal resistance may facilitate effective and efficient cooling of the power electronics unit.

Optionally, the second cooling unit comprises a third heat exchange surface that may correspond to an upper surface of the second hollow elongated body. In an embodiment, the power electronics unit is mounted on the third heat exchange surface (i.e., the upper surface of the second hollow elongated body). The second cooling unit further comprises a fourth heat exchange surface that may correspond to a side surface of the second hollow elongated body. The fourth heat exchange surface (i.e., the side surface of the second hollow elongated body) may be facing the first cooling unit, i.e., the second heat exchange surface or the side surface of the first hollow elongated body. Optionally, at least one of the third heat exchange surface and the fourth heat exchange surface may be supplied with a thermal interface material. As mentioned above, the third heat exchange surface and the fourth heat exchange surface are also provided with (or comprises) internal cavities adjacent thereto. Optionally, the cavities may be formed as a channel, groove, or pocket within the structure of the cooling unit. The cavities are at least partially filled with the thermal interface material or thermally conductive material. The third heat exchange surface may facilitate conduction, i.e., transfer of heat from the power electronics unit to the upper surface of the second hollow elongated body. The thermal resistance of the second heat exchange surface may be several orders of magnitude lower compared to that of the conventional heatsinks. The lower thermal resistance facilitates effective and efficient cooling of the power electronics unit.

Beneficially, the lateral heat exchange surfaces, namely, the first and second heat exchange surfaces, and the third and fourth heat exchange surfaces, incorporate cavities filled with the thermal interface material for a drastic reduction in the thermal resistance (or faster heat dissipation) between the corresponding cooling units, namely, the first and second cooling units, and the magnetic devices. Moreover, by arranging the power electronics unit with its printed circuit board oriented such that the side bearing the electronic components faces the magnetic devices, improved thermal conduction from the high-power components to the cooling units is achieved. Therefore, the overall cooling efficiency is enhanced, device operating temperatures are lowered, and the risk of overheating is substantially reduced.

The one or more magnetic devices are arranged between the first cooling unit and the second cooling unit. The one or more magnetic devices may occupy a space between the first cooling unit and the second cooling unit. In some embodiment, the one or more magnetic devices (i.e., magnetics) may be customized. Throughout the disclosure, the one or more magnetic devices refer to passive elements that rely on an internal magnetic field to alter electric current and/or voltage. The cooling arrangement may facilitate having shorter routes for high-power delivery to different components of the power electronics unit. This may minimize resistive losses, inductive losses, and capacitive losses. An example of a magnetics device is a transformer, an inductor, a coil or a pair of coils for transferring one voltage to another.

The arrangement of the one or more magnetic devices (i.e., magnetics) between the first cooling unit and the second cooling unit facilitates increasing a surface area of contact between the first cooling unit and the magnetics and a surface area of contact between the second cooling unit and the magnetics. Optionally, the one or more magnetic devices may be arranged such that the one or more magnetics devices are in contact with the second heat exchange surface and the fourth heat exchange surface. The second heat exchange surface of the first cooling unit, which may correspond to the side surface of the first hollow elongated body, may be in contact with the one or more magnetic devices. On the other hand, the fourth heat exchange surface of the second cooling unit, which may correspond to the side surface of the second hollow elongated body, may be in contact with the one or more magnetic devices. The contacts may facilitate transfer of heat from the one or more magnetic devices to the first hollow elongated body and the second hollow elongated body.

The second heat exchange surface may be supplied with a thermal interface material that facilitates conduction, i.e., transfer of heat from the one or more magnetic devices to the side surface of the first hollow elongated body (i.e., the second heat exchange surface of the first cooling unit) based on conduction. The thermal resistance of the second heat exchange surface may be several orders of magnitude lower compared to that of the conventional heatsinks. The lower thermal resistance of the second heat exchange surface may facilitate efficient heat transfer, and, thereby, effective cooling of the one or more magnetic devices. Similarly, the fourth heat exchange surface may be supplied with a thermal interface material that facilitates conduction, i.e., transfer of heat from the one or more magnetic devices to the side surface of the second hollow elongated body (i.e., the fourth heat exchange surface of the second cooling unit) based on conduction. The thermal resistance of the fourth heat exchange surface may be several orders of magnitude lower than that of the conventional heatsinks. The lower thermal resistance of the fourth heat exchange surface may facilitate efficient heat transfer, and thereby, effective cooling of the one or more magnetic devices.

In an embodiment, the one or more magnetic devices (i.e., magnetics) may be designed such that there is a match between the height of the magnetics and the height of the first cooling unit. Similarly, the height of the magnetics may match the height of the second cooling unit. In some embodiments, the first cooling unit, the second cooling unit, and the magnetics may be mechanically optimized.

The one or more fluid transfer means enable the transfer of fluid (such as liquid, air, or gas) through the first cooling unit and the second cooling unit. Optionally, the one or more fluid transfer means may comprise fans, blowers, compressors, or pumps. For example, fans may enable transfer of cool air through the first cooling unit and the second cooling unit. On the other hand, pumps may enable transfer of liquid (such as cold water) through the first cooling unit and the second cooling unit. The transfer or navigation of the fluid (facilitated by the one or more fluid transfer means) through the first cooling unit and the second cooling unit may enable ejection or dissipation of heat from each of the first cooling unit and the second cooling unit through convection means. Beneficially, the use of specific fluid transfer means ensures efficient and controlled movement of fluid through the cooling units, and improves the heat dissipation rate and ensures consistent cooling performance. Additionally, the flexibility to use different types of fluid transfer means (e.g., fans for air cooling or pumps for liquid cooling) allows the system to be adapted to various cooling requirements and environments.

Optionally, the cooling arrangement further comprises one or more fluid sources that may supply the fluid to the first cooling unit and the second cooling unit. The one or more fluid transfer means, i.e., fans, blowers, compressors, or pumps, may function as the one or more fluid sources that supply the fluid to the first cooling unit and the second cooling unit for cooling of the first cooling unit and the second cooling unit. For example, the fans may generate cool air and cause navigation of the cool air through each of the first cooling unit and the second cooling unit. The navigation of the cool air may lead to ejection or dissipation of heat (i.e., warm air) from each of the first cooling unit and the second cooling unit, thereby effectively cooling each of the first cooling unit and the second cooling unit.

In an embodiment, the one or more fluid transfer means may be coupled to the first cooling unit and the second cooling unit. For example, a first fan may be coupled to a first end of the first hollow elongated body of the first cooling unit. Thus, the first cooling unit may be equipped with the first fan. The first fan may be an axial fan, a diagonal fan, or a radial fan. The first fan may produce an air flow at the first end, which may navigate through the internal structure of the first hollow elongated body. The air flow may cause dissipation or ejection of heat from the first hollow elongated body (guide warm air out of the first hollow elongated body). The presence of the heat in the first hollow elongated body may be due to transfer of heat from the power electronics unit via the upper surface of the first hollow elongated body (i.e., the first heat exchange surface of the first cooling unit). The presence of the heat in the first hollow elongated body may be further due to transfer of heat from the one or more magnetic devices via the side surface of the first hollow elongated body (i.e., the second heat exchange surface of the first cooling unit). The navigating air flow may cause ejection of the heat from a second end of the first hollow elongated body.

In another example, a second fan may be coupled to a first end of the second hollow elongated body of the second cooling unit. Thus, the second cooling unit may be equipped with the second fan. The second fan may be an axial fan, a diagonal fan, or a radial fan. The second fan may produce an air flow at the first end, which may navigate through the internal structure of the second hollow elongated body and cause ejection or dissipation of heat from the second hollow elongated body (guide warm air out of the second hollow elongated body). The presence of the heat in the second hollow elongated body may be due to transfer of heat from the power electronics unit via the upper surface of the second hollow elongated body (i.e., the third heat exchange surface of the second cooling unit). The presence of the heat in the second hollow elongated body may be further due to transfer of heat from the one or more magnetic devices via the side surface of the second hollow elongated body (i.e., the fourth third heat exchange surface of the second cooling unit). The navigating air flow may cause ejection of the heat from a second end of the second hollow elongated body.

In an embodiment, the one or more fluid transfer means may facilitate transfer of fluid (such as air) through the one or more magnetic devices (i.e., the magnetics). Thus, the one or more fluid transfer means may function as fluid sources that may supply the fluid (that is transferred) for effective thermal handling of windings of the one or more magnetic devices. For example, a third fan may generate cool air and supply the cool air to the magnetics. The cool air may flow through the windings of the one or more magnetic devices, which may cool the one or more magnetic devices. The cool air may dissipate heat that may be generated at components of the one or more magnetic devices (such as high-power magnetic parts or windings) due to power dissipation at the components.

Optionally, the cooling arrangement further comprises at least one extension body that may be coupled to at least one of the first cooling unit and the second cooling unit. The at least one extension body may provide at least one passage for fluid to flow through the first cooling unit and the second cooling unit. Additionally, the at least one extension body may be coupled to at least one fluid transfer means or at least one fluid source for generation of a fluid and transfer of the fluid through the first cooling unit and the second cooling unit.

In an embodiment, the cooling arrangement may include two extension bodies, the first cooling unit, the second cooling unit, and a single fluid transfer means. A first end of the first hollow elongated body of the first cooling unit may be coupled to the fluid transfer means and a second end of the first hollow elongated body of the first cooling unit may be coupled to a first end of a first extension body. A second end of the first extension body may be coupled to a first end of the second hollow elongated body of the second cooling unit. A second end of the second hollow elongated body may be coupled to a first end of a second extension body.

The fluid transfer means may produce a fluid at the first end of the first hollow elongated body. The fluid transfer means may further cause the fluid to navigate through the first hollow elongated body and onto the first extension body. The fluid may collect heat from the first hollow elongated body during the navigation. The flow of the fluid through the first hollow elongated body may cause dissipation or ejection of heat from the first hollow elongated body to the first extension body. The fluid, mixed with heat collected from the first hollow elongated body, may navigate through the second hollow elongated body and onto the second extension body. During the navigation, the fluid, mixed with the heat collected from the first hollow elongated body, may further collect heat from the second hollow elongated body. The fluid in the second extension body may include the heat collected from the first hollow elongated body and the heat collected from the second hollow elongated body. The navigation of the fluid, mixed with the heat collected from the first hollow elongated body, through the second hollow elongated body may cause dissipation or ejection of heat from the second hollow elongated body. The fluid, mixed with the heat collected from the first hollow elongated body and the second hollow elongated body, may be ejected from a second end of the second extension body. This results in the cooling of the first cooling unit and the second cooling unit.

In another embodiment, the cooling arrangement may include two extension bodies, the first cooling unit, the second cooling unit, and two fluid transfer means. A first end of the first extension body may be coupled to a first fluid transfer means and a second end of the first extension body may be coupled to a first end of the first hollow elongated body of the first cooling unit. A first end of the second extension body may be coupled to a second fluid transfer means and a second end of the second extension body may be coupled to a first end of the second hollow elongated body of the second cooling unit.

The first fluid transfer means may produce a fluid at the first end of the first extension body. The fluid may navigate through the first extension body and through the internal structure of the first hollow elongated body. The navigation of the fluid may a cause ejection or dissipation of heat through a second end of the first hollow elongated body. The dissipation of the heat may be based on guidance of the heat through the second end of the first hollow elongated body.

Similarly, the second fluid transfer means may produce a fluid at the first end of the second extension body. The fluid may navigate through the second extension body and through the internal structure of the second hollow elongated body. The navigation of the fluid may a cause ejection or dissipation of heat through a second end of the second hollow elongated body. The dissipation of the heat may be based on guidance of the heat through the second end of the second hollow elongated body.

The present disclosure also relates to the second aspect as described above. Various embodiments and variants disclosed above, with respect to the aforementioned first aspect, apply *mutatis mutandis* to the second aspect.

The power electronics assembly includes the power electronics unit. The power electronics unit includes a Printed Circuit Board (PCB). A plurality of electronic components is arranged on a first side of the PCB. The first side of the PCB is facing away from the first cooling unit and the second cooling unit. A second side of the PCB is facing the one or more magnetics devices. The plurality of electronic components may include low-voltage components and high-power components. The PCB may be mounted on the first cooling unit and the second cooling unit. The second side of the PCB may face the first cooling unit and the second cooling unit along with the one or more magnetics devices. The heat generated at the plurality of electronic components due to power dissipation may be collected by the heat exchange surfaces of the first cooling unit and the second cooling units (i.e., the upper surfaces of the first hollow elongated body of the first cooling unit and the upper surfaces of the second hollow elongated body of the first second unit) based on conduction.

The construction of the cooling arrangement may facilitate connecting power electronic components (in the PCB) of the power electronics unit directly to the first cooling unit and the second cooling unit. If the power electronics unit is used critical high-frequency applications, there may be requirement for surface mount electronic components and a multilayer power electronics unit PCBs. The surface mount electronic components and the power electronics unit PCBs may have lesser harmful parasitic characteristics compared to through hole electronic components.

A technical effect of having the power electronics unit with the first side of the PCB facing away from the first cooling unit and the second cooling unit and the second side of the PCB facing the one or more magnetic devices is that this allows increasing surface area of contact between at least one of: the power electronics unit and the first cooling unit, the power electronics unit and the second cooling unit, or the power electronics unit and the one or more magnetic devices. The increased surface area allows efficient transfer of heat via conduction. The heat transfer may take place from the PCB to the heat exchange surfaces of the first cooling unit and the second cooling unit (i.e., the upper surfaces of the first hollow elongated body and the second hollow elongated body). The heat transfer may further take place from the one or more magnetic devices to the heat exchange surfaces of the first cooling unit and the second cooling unit (i.e., the side surfaces of the first cooling unit and the second hollow elongated body).

The geometry of the cooling units (i.e., the first cooling unit and the second cooling unit) of the cooling arrangement may be such that the cooling units are capable of holding heavy weighted magnetics (i.e., the one or more magnetic devices) in place during the manufacturing of the power electronics assembly. The design of the cooling arrangement may minimise dust ingression into power electronics components of the power electronics unit as flow of fluid can be directed throughout the cooling arrangement.

Optionally, the power electronics assembly further comprises at least one extension body that may be coupled to at least one of the first cooling unit and the second cooling unit. The at least one extension body provides at least one passage for fluid to flow through the first cooling unit and the second cooling unit.

A technical benefit of the at least one extension body is that the one or more fluid transfer means may enable transfer of fluid, generated by the at least one fluid source, from the first cooling unit to the second cooling unit via the at least one extension body. Additionally, the at least one extension body facilitates the transfer of fluid through the first cooling unit to the second cooling unit.

Optionally, the one or more fluid transfer means comprise fans, blowers, compressors, and pumps.

Optionally, at least one heat exchange surface of at least one of the first hollow elongated body or the second hollow elongated body is supplied with a thermal interface material.

The present disclosure also relates to the third aspect as described above. Various embodiments and variants disclosed above, with respect to the aforementioned first aspect and second aspect, apply *mutatis mutandis* to the third aspect.

Optionally, the method for cooling the power electronics assembly further comprises coupling the at least one extension body to the first cooling unit and the second cooling unit. The supply of fluid through each of the first cooling unit and the second cooling unit may be based on passage of the fluid from the first cooling unit to the extension body and, subsequently, from the extension body to the second cooling unit.

A cooling arrangement comprising a first cooling unit having a first hollow elongated body that provides a passage for a fluid to flow through the first cooling unit, a second cooling unit arranged parallel to and spaced apart from the first cooling unit, having a second hollow elongated body that provides a passage for a fluid to flow through the second cooling unit. Wherein one or more magnetic devices are arranged between the first cooling unit (and the second cooling unit and one or more fluid transfer means that enable transfer of fluid through the first cooling unit and the second cooling unit. Further technical effect of the arrangement is that the arrangement provides efficient cooling for the magnetics at the same time as it provides cooling for the power electronics. Furthermore, the design is compact as the magnetics are between the first and the second cooling units. In addition, manufacturing of the device is easier as the magnetics can be arranged between the cooling units and a robust package of cooling units and magnets can be formed. After that installation of the power electrics in top of the package can be done easily by soldering connectors from the magnetics to the power electronics PCB. This also make possible needed wires shorter (this reduces electromagnetic interference) as the magnetics can be arranged in contact (or nearly in contact) with PCB.

### DETAILED DESCRIPTION OF THE DRAWINGS

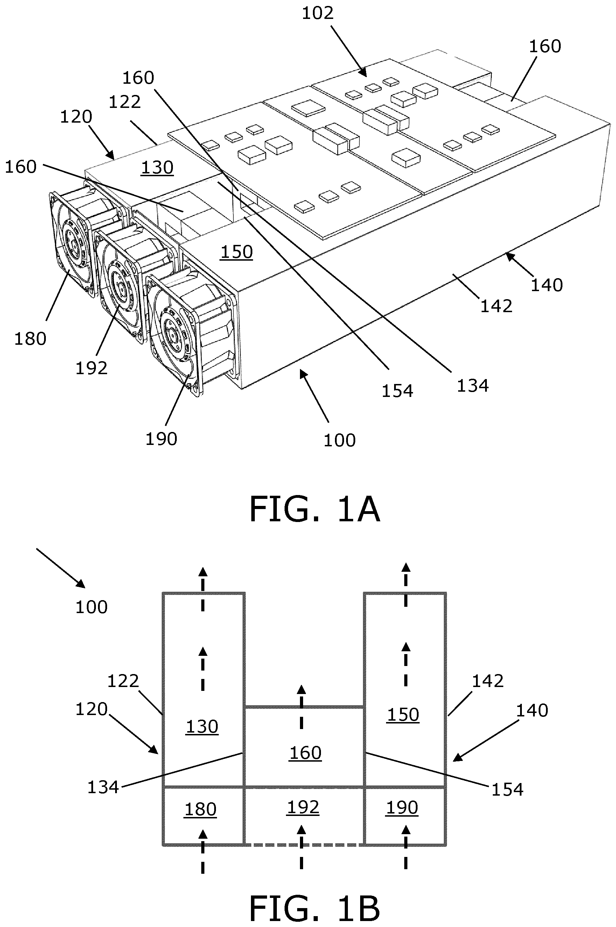

Referring to FIG. 1A, there is illustrated an exemplary power electronics assembly that includes a cooling arrangement **100** and a power electronics unit **102,** in accordance with an embodiment of the present disclosure. The cooling arrangement **100** includes a first cooling unit **120** having a first hollow elongated body **122.** The first hollow elongated body **122** provides a passage for a fluid to flow through the first cooling unit **120.** The cooling arrangement **100** further includes a second cooling unit **140** having a second hollow elongated body **142.** The second hollow elongated body **142** provides a passage for a fluid to flow through the second cooling unit **140.** The second cooling unit **140** may be arranged parallel to the first cooling unit **120** and spaced apart from the first cooling unit **120.** The cooling arrangement **100** further includes one or more magnetic devices **160.** The one or more magnetic devices **160** are arranged between the first cooling unit **120** and the second cooling unit **140.** Thus, the one or more magnetic devices **160** occupy a space (cavity) between the first cooling unit **120** and the second cooling unit **140.** The cooling arrangement **100** further includes one or more fluid transfer means that enable transfer of fluid through the first cooling unit **120** and the second cooling unit **140.** As shown in FIG. 1, the one or more fluid transfer means include a first fluid transfer means **180** and a second fluid transfer means **190.** A third fluid transfer means **192** may enable transfer of a fluid through windings of the one or more magnetic devices **160** for cooling the one or more magnetic devices **160** disposed in the space between the first cooling unit **120** and the second cooling unit **140.**

The first cooling unit **120** comprises a first heat exchange surface **130** and a second heat exchange surface **134.** The first heat exchange surface **130** corresponds to an upper surface of the first hollow elongated body **122.** The second heat exchange surface **134** corresponds to a side surface of the first hollow elongated body **122.** The side surface of the first hollow elongated body **122** is facing the second cooling unit **140.**

The second cooling unit **140** comprises a third heat exchange surface **150** and a fourth heat exchange surface **154.** The third heat exchange surface **150** corresponds to an upper surface of the second hollow elongated body **142.** The fourth heat exchange surface **154** corresponds to a side surface of the second hollow elongated body **142.** The side surface of the second hollow elongated body **142** is facing the first cooling unit **120.** The one or more magnetic devices **160** are arranged in contact with the second heat exchange surface **134** and the fourth heat exchange surface **154.** The second heat exchange surface **134** is opposite to the fourth heat exchange surface **154.**

Each of the first heat exchange surface **130,** the second heat exchange surface **134,** the third heat exchange surface **150,** and the fourth heat exchange surface **154** may be supplied with a thermal interface material.

The power electronics unit **102** includes a printed circuit board PCB. A plurality of electronic components may be arranged on a first side of the PCB. The first side of the PCB is facing away from the first cooling unit **120** and the second cooling unit **140.** A second side of the PCB is facing the one or more magnetic devices **160.** Magnetics **160** are electrically connected to the power electronics unit **102.**

The first heat exchange surface **130** of the first cooling unit **120** is facing the bottom side of the power electronics unit **102.** The second heat exchange surface **134** is substantially perpendicular to the first heat exchange surface **130** and is facing at least one of the two surfaces of the one or more magnetics devices **160.**

The third heat exchange surface **150** of the second cooling unit **140** is facing the bottom side of the power electronics unit **102.** The fourth heat exchange surface **154** is substantially perpendicular to the third heat exchange surface **150** and is facing at least one of the two surfaces of the one or more magnetics devices **160.**

The power electronics assembly, as shown in FIG. 1, is a highly compact structure that allows implementing both high-power magnetics and high-power electronics in a compact form for achieving highest power density.

It may be understood by a person skilled in the art that FIG. 1A depicts a simplified architecture of the power electronics assembly, for sake of clarity, which should not unduly limit the scope of the claims herein. It is to be understood that the specific implementation of the power electronics assembly is provided as an example and is not to be construed as limiting to specific shape of cooling units, number of cooling units, arrangement or placement of the cooling units, number of fluid transfer means, and number of magnetic devices. The person skilled in the art will recognize many variations, alternatives, and modifications of embodiments of the present disclosure.

Referring to FIG. 1B, there is illustrated a schematic of a top view of the exemplary cooling arrangement **100** for cooling the power electronics unit **102,** in accordance with an embodiment of the present disclosure. The top view of the exemplary cooling arrangement **100** shows the first heat exchange surface **130,** the second heat exchange surface **150,** and pathways through which fluid may flow through each of the first hollow elongated body **122,** the second hollow elongated body **142,** and the windings of the one or more magnetics devices **160.** The first fluid transfer means **180,** the second fluid transfer means **190,** and the third fluid transfer means **192** may also function as fluid sources that supply fluid to the first cooling unit **120,** the second cooling unit **140,** and the one or more magnetics devices **160.** The first hollow elongated body **122** may form a first channel that allows fluid, supplied by the first fluid transfer means **180,** to flow through the first cooling unit **120.** The second hollow elongated body **142** may form a second channel that allows fluid, supplied by the second fluid transfer means **190,** to flow through the second cooling unit **140.** The windings of the one or more magnetics devices **160** may form an intermediate channel between the first channel and the second channel. The intermediate channel allows fluid, supplied by the third fluid transfer means **192,** to flow through the windings of the one or more magnetics devices **160.**

FIG. 1B is merely an example, which should not unduly limit the scope of the claims herein. A person skilled in the art will recognize many variations, alternatives, and modifications of embodiments of the present disclosure.

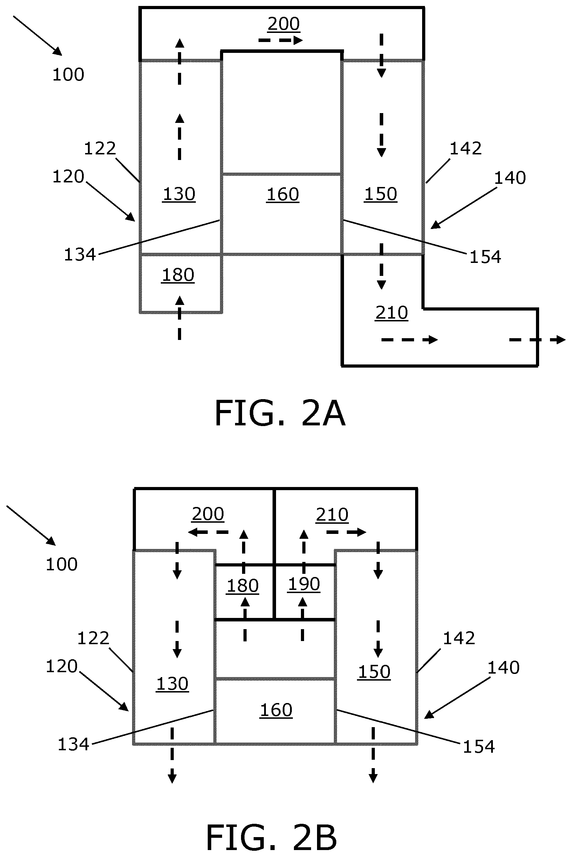

Referring to FIG. 2A, there is illustrated a schematic of a top view of the exemplary cooling arrangement **100** that includes two extension bodies, in accordance with an embodiment of the present disclosure. As shown in FIG. 2A, the cooling arrangement **100** comprises two extension bodies that are coupled to the first cooling unit **120** and the second cooling unit **140.** The extension bodies provide passages for fluid to flow through the first cooling unit **120** (i.e., the first hollow elongated body **122)** and the second cooling unit **140** (i.e., the second hollow elongated body **142).**

A first end of the first hollow elongated body **122** of the first cooling unit **120** may be coupled to the first fluid transfer means **180** and a second end of the first hollow elongated body **122** may be coupled to a first end of a first extension body **200.** A second end of the first extension body **200** may be coupled to a first end of the second hollow elongated body **142** of the second cooling unit **140.** A second end of the second hollow elongated body **142** may be coupled to a first end of a second extension body **210.**

The first fluid transfer means **180** may cause the fluid to navigate through the first hollow elongated body **122** and onto the first extension body **200.** The fluid collects heat from the first hollow elongated body **122** during the navigation. The flow of the fluid through the first hollow elongated body **122** causes dissipation or ejection of heat from the first hollow elongated body **122** to the first extension body **200.** The fluid, now mixed with heat collected from the first hollow elongated body **122,** may navigate through the second hollow elongated body **142** and onto the second extension body **210.** During the navigation, the fluid, mixed with the heat collected from the first hollow elongated body **122,** may further collect heat from the second hollow elongated body **142.** The fluid in the second extension body **210** may include the heat collected from the first hollow elongated body **122** and the heat collected from the second hollow elongated body **142.** The navigation of the fluid, mixed with the heat collected from the first hollow elongated body **122,** through the second hollow elongated body **142** may cause dissipation or ejection of heat from the second hollow elongated body **142.** The fluid, now mixed with the heat collected from the first hollow elongated body **122** and the second hollow elongated body **142,** may be ejected from a second end of the second extension body **210.**

FIG. 2A is merely an example, which should not unduly limit the scope of the claims herein. A person skilled in the art will recognize many variations, alternatives, and modifications of embodiments of the present disclosure.

Referring to FIG. 2B, there is illustrated another schematic of a top view of the cooling arrangement **100** that includes two extension bodies, in accordance with an embodiment of the present disclosure. The cooling arrangement **100** may include the first cooling unit **120,** the second cooling unit **140,** the first fluid transfer means **180,** the second fluid transfer means **190,** the first extension body **200,** and the second extension body **210.** A first end of the first extension body **200** may be coupled to the first fluid transfer means **180** and a second end of the first extension body **200** may be coupled to a first end of the first hollow elongated body **122** of the first cooling unit **120.** A first end of the second extension body **210** may be coupled to the second fluid transfer means **190** and a second end of the second extension body **210** may be coupled to a first end of the second hollow elongated body **142** of the second cooling unit **140.**

The first fluid transfer means **180** may produce a fluid at the first end of the first extension body **200.** The fluid may navigate through the first extension body **200** and through the internal structure of the first hollow elongated body **122.** The navigation of the fluid may a cause ejection or dissipation of heat through a second end of the first hollow elongated body **122.** The dissipation of the heat may be based on guidance of the heat through the second end of the first hollow elongated body **122.** Similarly, the second fluid transfer means **190** may produce a fluid at the first end of the second extension body **210.** The fluid may navigate through the second extension body **210** and through the internal structure of the second hollow elongated body **142.** The navigation of the fluid may a cause ejection or dissipation of heat through a second end of the second hollow elongated body **142.** The dissipation of the heat may be based on guidance of the heat through the second end of the second hollow elongated body **142.**

FIG. 2B is merely an example, which should not unduly limit the scope of the claims herein. A person skilled in the art will recognize many variations, alternatives, and modifications of embodiments of the present disclosure.

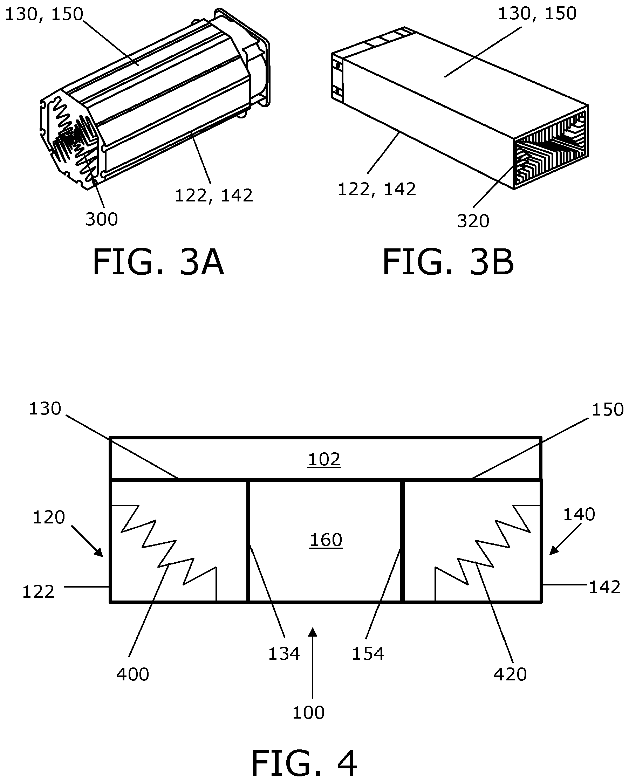

Referring to FIG. 3A, there is illustrated an exemplary hollow elongated body of a cooling unit that is of a polygonal elongated shape and comprises a plurality of fins, in accordance with an embodiment of the present disclosure. The cooling unit may be the first cooling unit **120** or the second cooling unit **140.** The first hollow elongated body **122** of the first cooling unit **120** or the second hollow elongated body **142** of the second cooling unit **140** is of a polygonal elongated shape. The first hollow elongated body **122** or the second hollow elongated body **142** includes a plurality of fins **300** which enable dissipation of heat from the first hollow elongated body **122** or the second hollow elongated body **142.** The heat may have been collected from the power electronics unit **102** and transferred via conduction to the first hollow elongated body **122** or the second hollow elongated body **142** via the first heat exchange surface **130** or the second heat exchange surface **150.**

FIG. 3A is merely an example, which should not unduly limit the scope of the claims herein. A person skilled in the art will recognize many variations, alternatives, and modifications of embodiments of the present disclosure.

Referring to FIG. 3B, there is illustrated an exemplary hollow elongated body of a cooling unit that is of a rectangular shape and comprises a plurality of fins, in accordance with an embodiment of the present disclosure. The cooling unit may be the first cooling unit **120** or the second cooling unit **140.** The first hollow elongated body **122** of the first cooling unit **120** or the second hollow elongated body **142** of the second cooling unit **140** is of a rectangular shape. The first hollow elongated body **122** or the second hollow elongated body **142** includes a plurality of fins **320** which enable dissipation of heat from the first hollow elongated body **122** or the second hollow elongated body **142.** The heat may have been collected from the power electronics unit **102** and transferred via conduction to the first hollow elongated body **122** or the second hollow elongated body **142** via the first heat exchange surface **130** or the second heat exchange surface **150.**

FIG. 3B is merely an example, which should not unduly limit the scope of the claims herein. A person skilled in the art will recognize many variations, alternatives, and modifications of embodiments of the present disclosure.

Referring to FIG. 4, there is illustrated a schematic of a backside view of an exemplary power electronics assembly that includes the cooling arrangement **100** and the power electronics unit **102,** in accordance with an embodiment of the present disclosure. The backside view of the first hollow elongated body **122** includes a plurality of fins **400.** The backside view of the second hollow elongated body **142** includes a plurality of fins **420.** The power electronics unit **102** may be mounted on the cooling arrangement **100.** As such, the first heat exchange surface **130** of the first cooling unit **120** is in contact with the bottom side of the power electronics unit **102.** The second heat exchange surface **134** is substantially perpendicular to the first heat exchange surface **130.** The second heat exchange surface **134** is in contact with a first surface of the one or more magnetics devices **160.** The third heat exchange surface **150** of the second cooling unit **140** is in contact with the bottom side of the power electronics unit **102.** The fourth heat exchange surface **154** is substantially perpendicular to the third heat exchange surface **150.** The fourth heat exchange surface **154** is in contact with a second surface of the one or more magnetics devices **160.**

FIG. 4 is merely an example, which should not unduly limit the scope of the claims herein. A person skilled in the art will recognize many variations, alternatives, and modifications of embodiments of the present disclosure.

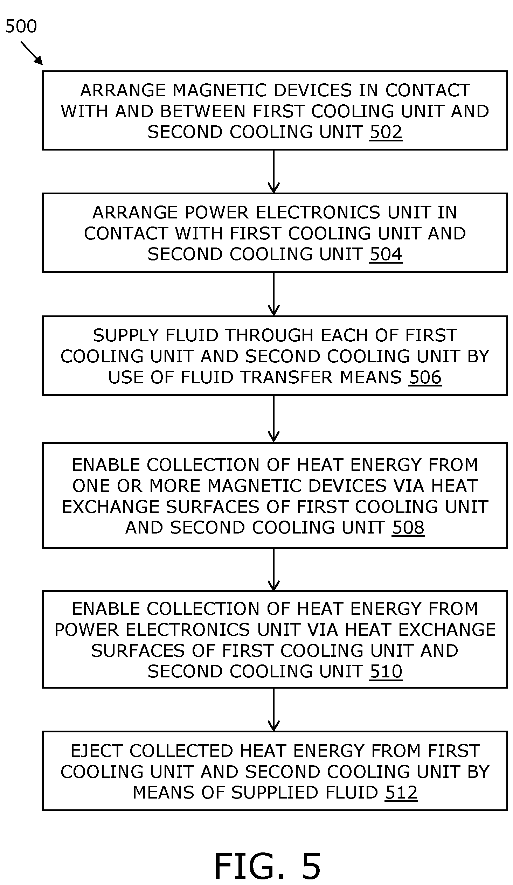

Referring to FIG. 5, depicted are steps of a method **500** for cooling a power electronics assembly, in accordance with an embodiment of the present disclosure, in accordance with an embodiment of the present disclosure. At step **502,** one or more magnetic devices **160** is arranged in contact with and between the first cooling unit **120** and the second cooling unit **140.** The second cooling unit **140** is in parallel to, and spaced apart from, the first cooling unit **120.** At step **504,** the power electronics unit **102** is arranged in contact with the first cooling unit **120** and the second cooling unit **140.** A first side (top side) of the power electronics unit **102** is facing away from the first cooling unit **120** and the second cooling unit **140.** A second side (bottom side) of the power electronics unit **102** is facing towards the one or more magnetic devices **160.** At step **506,** fluid is supplied through each of the first cooling unit **120** and the second cooling unit **140** by use of one or more fluid transfer means, i.e., the first fluid transfer means **180,** the second fluid transfer means **190,** and the third fluid transfer means **192.** At **508,** collection of heat energy from the one or more magnetic devices **160** via heat exchange surfaces (i.e., the second heat exchange surface **134** and the fourth heat exchange surface **154)** of the first cooling unit **120** and the second cooling unit **140,** in contact with the one or more magnetic devices **160,** is enabled. At **510,** collection of heat energy from the power electronics unit **102,** via heat exchange surfaces (i.e., the first heat exchange surface **130** and the third heat exchange surface **150)** of the first cooling unit **120** and the second cooling unit **140,** in contact with the second side of the power electronics unit **102,** is enabled. At **512,** the collected heat energy from the first cooling unit **120** and the second cooling unit **140** is ejected by means of the supplied fluid.

The aforementioned steps are only illustrative and other alternatives can also be provided where one or more steps are added, one or more steps are removed, or one or more steps are provided in a different sequence without departing from the scope of the claims herein.

## Claims

1. A cooling arrangement (100), comprising:
- a first cooling unit (120) having a first hollow elongated body (122) that provides a passage for a fluid to flow through the first cooling unit (120);
- a second cooling unit (140), arranged parallel to and spaced apart from the first cooling unit (120), having a second hollow elongated body (142) that provides a passage for a fluid to flow through the second cooling unit (140);
- one or more magnetic devices (160) arranged between the first cooling unit (120) and the second cooling unit (140); and
- one or more fluid transfer means (180, 190, 192) that enable transfer of fluid through the first cooling unit (120) and the second cooling unit (140).

2. The cooling arrangement (100) according to claim 1, wherein the cooling arrangement further comprises:
- at least one extension body (200, 210) coupled to at least one of the first cooling unit (120) and the second cooling unit (140), wherein the at least one extension body provides at least one passage for fluid to flow through the first cooling unit and the second cooling unit.

3. The cooling arrangement (100) according to any of the preceding claims, wherein the one or more fluid transfer means (180, 190, 192) comprise fans, blowers, compressors, or pumps.

4. The cooling arrangement (100) according to any of the preceding claims, wherein each of the first hollow elongated body (122) and the second hollow elongated body (142) is of a rectangular shape or a polygonal elongated shape.

5. The cooling arrangement according to any of the preceding claims wherein the first hollow elongated body (122) is formed by a first heat sink profile and a casing and/or the second hollow elongated body (142) is formed by a second heat sink profile and the casing.

6. The cooling arrangement (100) according to any of the preceding claims, wherein each of the first hollow elongated body (122) and the second hollow elongated body (142) further comprises a plurality of fins (300, 320, 400, 420).

7. The cooling arrangement (100) according to any of the preceding claims,
wherein the first cooling unit (120) comprises a first heat exchange surface (130) that corresponds to an upper surface of the first hollow elongated body (122), and a second heat exchange surface (134) that corresponds to a side surface of the first hollow elongated body (122) facing the second cooling unit (140),
wherein the second cooling unit (140) comprises a third heat exchange surface (150) that corresponds to an upper surface of the second hollow elongated body (142), and a fourth heat exchange surface (154) that corresponds to a side surface of the second hollow elongated body (142) facing the first cooling unit (120), and
wherein the one or more magnetic devices (160) are arranged in contact with the second heat exchange surface (134) and the fourth heat exchange surface (154).

8. The cooling arrangement (100) according to claim 7, wherein at least one of the first heat exchange surface (130), the second heat exchange surface (134), the third heat exchange surface (150), or the fourth heat exchange surface (154) is supplied with a thermal interface material.

9. The cooling arrangement (100) according to claim 1, wherein the cooling arrangement further comprises one or more fluid sources that supply fluid to the first cooling unit (120) and the second cooling unit (140).

10. A power electronics assembly comprising:
- a cooling arrangement (100), comprising:
- a first cooling unit (120) having a first hollow elongated body (122) that provides a passage for a fluid to flow through the first cooling unit (120),
- a second cooling unit (140), arranged parallel to and spaced apart from the first cooling unit (120), having a second hollow elongated body (142) that provides a passage for a fluid to flow through the second cooling unit (140),
- one or more magnetic devices (160) arranged between the first cooling unit (120) and the second cooling unit (140), and
- one or more fluid transfer means (180, 190, 192) that enable transfer of fluid through the first cooling unit (120) and the second cooling unit (140); and
- a power electronics unit (102) that includes a printed circuit board (PCB), wherein a plurality of electronic components is arranged on a first side of the PCB, wherein the first side of the PCB is facing away from the first cooling unit and the second cooling unit, and wherein a second side of the PCB is facing the one or more magnetic devices.

11. The power electronics assembly according to claim 10, wherein the power electronics assembly further comprises:
- at least one extension body (200, 210) coupled to at least one of the first cooling unit (120) and the second cooling unit (140), wherein the at least one extension body provides at least one passage for fluid to flow through the first cooling unit and the second cooling unit.

12. The power electronics assembly according to claims 10 and 11, wherein the one or more fluid transfer means (180, 190, 192) comprise fans, blowers, compressors, and pumps.

13. The power electronics assembly according to claims 10 and 11, wherein at least one heat exchange surface (130, 134, 150, 154) of at least one of the first hollow elongated body (122) or the second hollow elongated body (142) is supplied with a thermal interface material.

14. A method (500) for cooling a power electronics assembly, the method comprising:
- arranging one or more magnetic devices (160) in contact with and between a first cooling unit (120) and a second cooling unit (140), wherein the second cooling unit is in parallel to and spaced apart from the first cooling unit;
- arranging a power electronics unit (102) in contact with the first cooling unit and the second cooling unit, wherein a first side of the power electronics unit is facing away from the first cooling unit and the second cooling unit, and wherein a second side of the power electronics unit is facing towards the one or more magnetic devices;
- supplying fluid through each of the first cooling unit and the second cooling unit by use of one or more fluid transfer means (180, 190, 192);
- enabling collection of heat energy from the one or more magnetic devices via heat exchange surfaces (134, 154) of the first cooling unit and the second cooling unit in contact with the one or more magnetic devices;
- enabling collection of heat energy from the power electronics unit via heat exchange surfaces (130, 150) of the first cooling unit and the second cooling unit in contact with the second side of the power electronics unit; and
- ejecting the collected heat energy from the first cooling unit and the second cooling unit by means of the supplied fluid.

15. The method (500) according to claim 14, further comprising:
- coupling at least one extension body (200, 210) to the first cooling unit (120) and the second cooling unit (140), wherein the supply of fluid through each of the first cooling unit and the second cooling unit is based on passage of the fluid from the first cooling unit to the extension body and, subsequently, from the extension body to the second cooling unit.
